# EUROPEAN PATENT APPLICATION

(11) **EP 2 509 396 A1**
(43) Date of publication of application: **10.10.2012**
(21) Application number: 10834561.2
(22) Date of filing: 01.12.2010
(51) Int. Cl.: H05B 33/10, H01L 51/50

(54) **DONOR SUBSTRATE, PATTERNING METHOD, AND METHOD FOR PRODUCING DEVICE**

(30) Priority: 03.12.2009 JP 2009275266
(71) Applicant: Toray Industries, Inc., Tokyo 103-8666 (JP)
(72) Inventor: FUJIMORI, Shigeo, Otsu-shi Shiga 520-8558 (JP); TANIMURA, Yasuaki, Otsu-shi Shiga 520-8558 (JP); NISHIMURA, Seiichiro, Otsu-shi Shiga 520-8558 (JP)
(74) Representative: Hoefer & Partner
(86) International application number: PCT/JP2010/071431
(87) International publication number: WO 2011/068111

(57) **Abstract**

Disclosed is a donor substrate including a support; a light-to-heat conversion layer and a transfer prevention layer formed on the support; and a transferring material layer formed on a top surface of the light-to-heat conversion layer and the transfer prevention layer; wherein a transfer region and an antitransfer region are formed by combinations of the light-to-heat conversion layer and the transfer prevention layer, and the transferring material layer is formed on the whole surface of the transfer region and at least one part of the antitransfer region. The present invention provides a patterning method which enables large-scale and high-accuracy fine patterning at low cost without causing deterioration of characteristics of thin films which constitute devices such as organic light emitting devices, and a method for producing a device.

## Description

### Technical Field

The present invention relates to a method for patterning a thin film which constitutes devices such as organic light emitting devices, organic TFTs, photoelectric transducers and various sensors, and a method for producing a device using such a patterning method.

### Background Art

An organic light emitting device is a light emitting device in which electrons injected from a cathode and holes injected from an anode are recombined in an organic emitting layer interposed between both electrodes. Since C. W. Tang et al. of Eastman Kodak Company have showed that an organic light emitting device emits light at a high luminance, many research institutes have made a study on this technology.

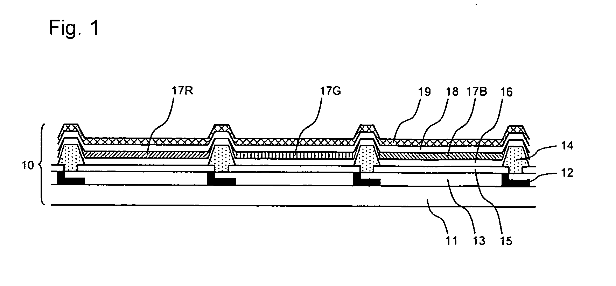

Practical use of this light emitting device as a color display has made progress since it is thin and capable of emitting light at a high luminance under a low driving voltage, and is also capable of obtaining various luminescent colors including three primary colors, red (R), green (G) and blue (B) by using various organic materials in an emitting layer. For example, an active matrix type color display shown in Fig. 1 requires technology in which emitting layers 17R, 17G and 17B corresponding to the respective R, G and B subpixels constituting pixels are patterned at a high accuracy. In order to realize a high-performance organic light emitting device, a multi-layered structure is required and it is necessary to stack a hole injection layer, a hole transporting layer, an emitting layer, an electron transporting layer, electron injection layer and the like, each having a typical film thickness of 0.1 µm or less, in this order.

There have hitherto been used a wet process (coating method) such as a photolithography method, an ink-jet method or a printing method in fine patterning of a thin film. Particularly, application of the ink-jet method and printing method to the organic light emitting device has been intensively studied because of high efficiency in utilizing of the material. However, it is difficult to completely prevent a change in form of an ultra-thin under layer and undesirable mixing in case of applying a photoresist, an ink or the like on the under layer formed previously in the wet process, and thus usable material is limited. It is difficult for the thin film formed by drying the solution to achieve film thickness uniformity in the pixel and uniformity between pixels in the substrate, and thus current convergence and device degradation associated with film thickness unevenness occurs, resulting in deterioration of performances as a display. There also arose problems such as impurities originally contained in the solution, impurities mixed in the solution during the process from application to drying, and an influence of a trace amount of the residual solvent exerted on device performances after drying.

To prevent the above-mentioned change in form of the under layer, there is disclosed technology in which an organic light emitting material is pattern-formed on a donor substrate in advance, and the pattern is transferred to a device substrate (see Patent Documents 1 to 3). However, since the organic light emitting material on the donor substrate is actually patterned by a coating method, it is necessary to newly develop a soluble organic light emitting material, as the major premise, and problems such as film thickness unevenness and impurities could not be still solved.

There has been examined, as a method for patterning a thin film by a dry process, having an advantage such as less influence of film thickness unevenness and impurities in principle, a mask deposition method. An emitting layer of a small-sized organic light emitting display, which is actually put into practice, is exclusively patterned by this method. However, since it is necessary for a deposition mask to form an accurate hole on a metal plate, it is difficult to compatibilize upsizing with accuracy.
It was also difficult to apply to a large-scale organic light emitting display since contact between the substrate and deposition mask is impaired by upsizing.

To realize upsizing by a dry process, there is developed a selective transfer system in which a light-to-heat conversion layer is formed on a donor substrate and an organic light emitting material is formed on the whole surface thereof by thermal deposition, and then a part of an organic light emitting material formed on the whole surface is pattern-transferred to a device substrate using heat generated by partially irradiating the light-to-heat conversion layer with high-intensity laser (see Patent Documents 4 to 5). However, it is necessary to irradiate with high-intensity laser within a very short time so as to prevent transfer boundary from becoming unclear due to diffusion of generated heat in a cross direction. It is difficult to accurately control maximum ultimate temperature since the organic light emitting material is heated within a very short time. Therefore, the organic light emitting material is particularly likely to reach a decomposition temperature or higher, resulting in deterioration of device performances. Furthermore, alignment with high accuracy every RGB subpixels requires a large facility burden and also the treatment time of one substrate increases as the total numbers of pixels increases due to upsizing of the substrate.

To relieve the burden of high-accuracy alignment of the above laser, Patent Documents 4 to 5 disclose technologies in which light shielding film is formed on a rear surface of a donor substrate and a photomask is disposed. However, even if a glass substrate of a donor substrate has a thickness of 0.7 mm, a shape of laser to be irradiated on an outermost light-to-heat conversion layer causes disturbance in a converging optical system. Even if laser is parallel light, an error of 5 µm arises at laser end to be irradiated on the light-to-heat conversion layer only by causing inclination of an incident angle by 0.4° from a direction of a normal line. Therefore, there was a patterning accuracy-related problem.

To relive the above-mentioned burden of high-accuracy alignment of laser, there is disclosed technology of a donor substrate in which two kinds of light-to-heat conversion layers each having a different light absorption intensity are used in combination (Patent Document 6). However, it is necessary to use special laser mainly in an ultraviolet region so as to increase a difference in light absorption. Therefore, not only an expensive light source is required, but also it may be impossible to use an inexpensive glass substrate as a support because of a light transmittance, and thus causing cost-related problems. Furthermore, since the total film thickness of the light-to-heat conversion layer in a transfer region increases due to mechanical reason, a temperature rise in a transfer region is comparatively low even if light with the same energy is irradiated. To the contrary, since the light-to-heat conversion layer in an antitransfer region has a small total film thickness, the temperature is raised to a given level by a part of light absorbed even in case of a large reflectance. Therefore, it was particularly difficult to increase a difference in an ultimate temperature between the transfer region and antitransfer region, using an inexpensive laser light source in the visible and near infrared range (to sufficiently control the ultimate temperature in the antitransfer region).

Alternatively, there is disclosed, as another technique of relieving the burden of high-accuracy alignment of laser, technology of a donor substrate in which a reflection layer pattern and a light-to-heat conversion layer are used in combination (Patent Document 7). However, because of the mechanism in which a transfer layer corresponding to a heat generation region is selectively transferred to an acceptor substrate by causing a decease in adhesion due to heat, when a level difference between a heat generation region (transfer region) and a non-heat generation region (antitransfer region) is increased, the transfer layer in the heat generation region does not reach the acceptor substrate. When a thin reflection layer pattern is formed so as to decrease the level difference, laser is not sufficiently reflected to cause heating up to the light-to-heat conversion layer of the non-heat generation region, resulting in transfer up to the transfer layer of the non-heat generation region. In case of a small level difference, due to an influence of slight irregularity of a base substrate, there arises the place where the transfer layer is directly into contact with the acceptor substrate in both heat generation and non-heat generation regions on the donor substrate, and thus undesired adhesion of the transfer material is likely to occur. Since moderate flexibility is required to a base substrate and a resin film is used, it is difficult to reduce irregularity of the base substrate per se compared with the above-mentioned level difference. Because of inferior dimensional accuracy of the base substrate per se compared with the glass substrate, it becomes difficult to align the donor substrate with acceptor substrate with high accuracy as the acceptor substrate is upsized.

### Prior Art Documents

### Patent Documents

Patent Document 1: Japanese Unexamined Patent Publication (Kokai) No. 2002-260854
Patent Document 2: Japanese Unexamined Patent Publication (Kokai) No. 2009-146715
Patent Document 3: Japanese Unexamined Patent Publication (Kokai) No. 2009-187810
Patent Document 4: Japanese Patent No. 3,789,991
[Patent Document 5] Japanese Unexamined Patent Publication (Kokai) No. 2007-173145
[Patent Document 6] Japanese Unexamined Patent Publication (Kokai) No. 2009-199856
[Patent Document 7] Japanese Unexamined Patent Publication (Kokai) No. 2006-123546

### Disclosure of the Invention

### Problems to be Solved by the Invention

As mentioned above, it was difficult to stably realize fine patterning at low cost while compatibilizing upsizing with accuracy, and suppressing damage to an organic light emitting material, mixing of impurities and the occurrence of film thickness unevenness in the prior art. Particularly, in a laser transfer method, there was not a technique in which high-accuracy patterning is realized within a short treatment time without using a complicated optical system or a special light source.

An object of the present invention is to solve these problems, and thus providing a patterning method which enables large-scale and high-accuracy fine patterning at low costs without causing deterioration of characteristics of thin films which constitute devices such as organic light emitting devices.

### Means for Solving the Problems

The present invention has been made by intensive study so that conventional problems can be solved even by a transfer method using laser in the visible and near infrared range which is easy to use.

Namely, the present invention is directed to a donor substrate including a support; a light-to-heat conversion layer and a transfer prevention layer formed on the support; and a transferring material layer formed on a top surface of the light-to-heat conversion layer and the transfer prevention layer; wherein a transfer region and an antitransfer region are formed by combinations of the light-to-heat conversion layer and the transfer prevention layer, and the transferring material layer is formed on the whole surface of the transfer region and at least one part of the antitransfer region.

The present invention also includes a patterning method, which includes arranging the above donor substrate and a device substrate oppositely to each other; and irradiating light from the support side of the donor substrate so that at least one part of a transfer region and at least one part of an antitransfer region are simultaneously heated, thereby transferring only a transfer region portion of a transferring material layer to the device substrate.

The present invention also includes a method for producing a device, which includes patterning at least one layer of layers constituting a device by the above method.

### Effects of the Invention

The present invention exerts remarkable effect of realizing large-scale and high-accuracy fine patterning at low costs without causing deterioration of thin films which constitute devices such as organic light emitting devices.

### Brief Description of the Drawings

Fig. 1 is a cross-sectional view showing an example of an organic light emitting device in which an emitting layer is patterned by the present invention.
Fig. 2 is a cross-sectional view showing an example of a method for patterning an emitting layer of an organic light emitting device according to the present invention.
Fig. 3 is a plan view showing an example of a light irradiation method in Fig. 2(a).
Fig. 4 is a cross-sectional view showing an example of a patterning method according to the present invention.
Fig. 5 is a perspective view showing another example of a light irradiation method in the present invention.
Fig. 6 is a perspective view showing another example of a light irradiation method in the present invention.
Fig. 7 is a perspective view showing another example of a light irradiation method in the present invention.
Fig. 8 is a perspective view showing another example of a light irradiation method in the present invention.
Fig. 9 is a cross-sectional view showing another example of a light irradiation method in the present invention.
Fig. 10 is a plane view showing another example of a light irradiation method in the present invention.
Fig. 11 is a plane view showing another example of a light irradiation method in the present invention.
Fig. 12 is a perspective view showing another example of a light irradiation method in the present invention.
Fig. 13 is a schematic diagram explaining intensity distribution of light and a change in temperature of transferring material layer with time in the present invention.
Fig. 14 is a perspective view showing an example of a method for forming irradiation light in the present invention.
Fig. 15 is a cross-sectional view showing an example of a donor substrate in the present invention.
Fig. 16 is a cross-sectional view showing another example of a donor substrate in the present invention.
Fig. 17 is a cross-sectional view showing another example of a donor substrate in the present invention.
Fig. 18 is a cross-sectional view showing another example of a donor substrate in the present invention.
Fig. 19 is a plane fluorescence micrograph of a donor substrate before and after transfer in Example 1.

### Mode for Carrying Out the Invention

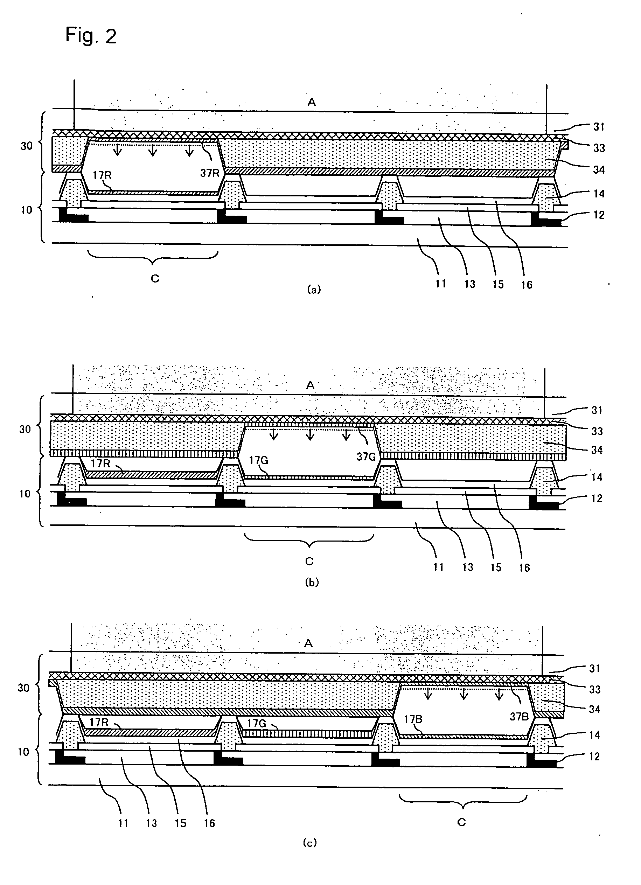

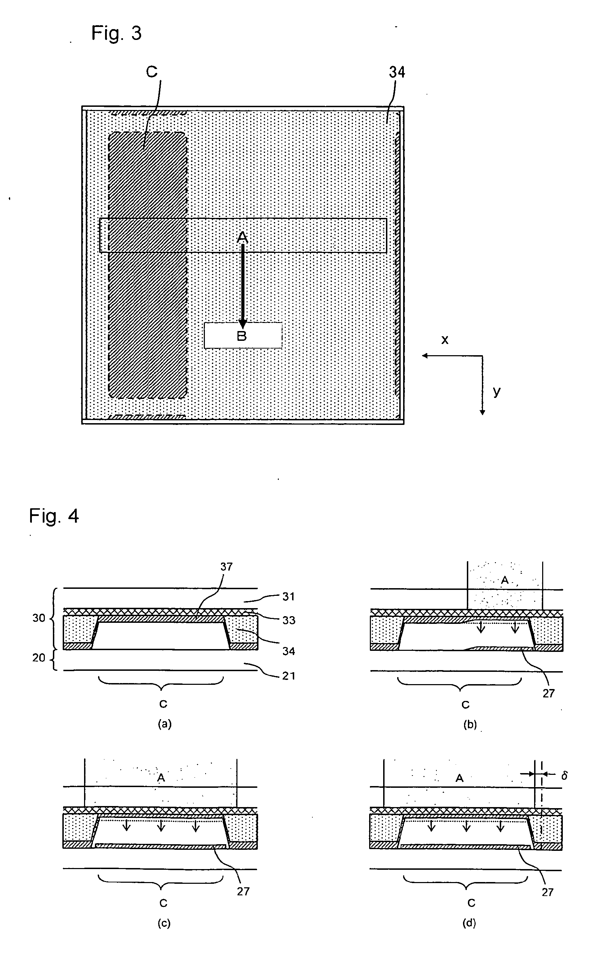

Fig. 2 and Fig. 3 are a cross-sectional view and a plane view which show an example of a patterning method of the present invention. In many drawings used in the present description, a minimum unit of RGB subpixels constituting a lot of pixels in a color display is picked out and described. To assist understanding, magnification in a lengthwise direction (direction vertical to substrate) is enlarged compared with a cross direction (substrate in-plane direction).

In Figs. 2(a), 2(b) and 2(c), a donor substrate 30 is composed of a support 31, a light-to-heat conversion layer 33, a transfer prevention layer 34, and a transferring material layer 37 formed on the whole top surface of the light-to-heat conversion layer and the transfer prevention layer. In this example, the transferring material layer 37 is a deposited film made of the respective RGB light emitting materials of an organic light emitting device. Particularly, a red light emitting material is referred to as 37R, a green light emitting material is referred to as 37G, and a blue light emitting material is referred to as 37B, respectively. In this example, the portion where the transfer prevention layer 34 is not formed of the donor substrate 30 would serve as a transfer region, while the portion where the transfer prevention layer 34 is formed would serves as an antitransfer region. An organic light emitting device (device substrate) 10 is composed of a substrate 11, and a TFT (including extraction electrode) 12, a planarizing film 13, an insulating layer 14, a first electrode 15 and a hole transporting layer 16 formed thereon. These are for illustrative purpose only and the configuration of the respective substartes are not limited thereto, as mentioned below.

As shown in Fig. 2(a), in a state where the position of the transfer prevention layer 34 of the donor substrate 30 and the position of the insulating layer 14 of the device substrate 10 are aligned, both substrates are arranged so as to face each other. Laser is incident from the support 31 side of the donor substrate 30 and absorbed to the light-to-heat conversion layer 33, and then the transfer region portion of the transferring material layer 37R is heated to vaporize by heat generated thereon. The vaporized transferring material layer 37R is accumulated on the portion corresponding to the transfer region on the hole transporting layer 16 of the device substrate 10 to form an emitting layer 17R. In such a manner, a pattern of the transferring material layer 37R is transferred to the emitting layer 17R. The antitransfer region portion of the transferring material layer 37R remains adhered on the transfer prevention layer 34 since the thick transfer prevention layer 34 is inserted between the light-to-heat conversion layer 33 and the transferring material layer 37R and thus the transferring material layer 37R is not heated to the temperature required for vaporization. Therefore, even if the transferring material layer 37R is formed on the whole surface of the light-to-heat conversion layer 33 and the transfer prevention layer 34, it is possible to only a transfer material of the transfer region portion. Thus, according to the method of the present invention, since it is not necessary to pattern-form a transferring material layer only in the transfer region on the donor substrate by an ink-jet method, a printing method or the like, the transferring material layer can be formed by a deposition method or the like, and thus the range of applicable materials is widen.

Fig. 3 is a schematic view in which a state of laser irradiation is viewed from the support 31 side of the donor substrate 30 in Fig. 2(a). Since the light-to-heat conversion layer 33 formed on the whole surface is present, neither transfer prevention layer 34 nor a transfer region C is actually seen from the support 31 (glass substrate) side. They were shown in the drawing by a dotted line so as to explain a positional relation with laser. In an aspect shown in Fig. 3, laser beam has a rectangular shape and is scanned in a direction vertical to the arrangement of the transfer region C. The laser beam may be relatively scanned, and the laser may be moved and/or a set of the donor substrate 30 and the device substrate 20 may be moved.

Herein, as shown in Fig. 3, it is the feature in the aspect of Fig. 2 and Fig. 3 that laser is irradiated so that at least one part of the transfer region and at least one part of the antitransfer region are simultaneously heated. In such way, since light may be irradiated with a wide range on the donor substrate, it is not necessary for laser to align with high accuracy every RGB subpixels. As mentioned above, even if the antitransfer region is irradiated with laser, the thick transfer prevention layer 34 prevents transfer of heat, and thus transfer in the antitransfer region does not occur. While an example of light irradiation with a width for one pixel (one set of RGB subpixels) was shown in Fig. 2, it is possible to adjust the treatment time of one substrate within a short time by transferring the emitting layer 17 corresponding to plural pixels at a time using a wide range of light even if the total numbers of pixels increases by upsizing of the substrate. Next, as shown in Figs. 2(b) and 2(c), patterning of emitting layers 17R, 17G and 17B is completed by similarly forming emitting layers 17G, 17B in a sequential order using another donor substrate 30 in which transferring material layers 37G, 37B are respectively formed on the whole surface. Symbols 17R, 17G and 17B mean a red emitting layer, a green emitting layer and a blue emitting layer, respectively.

In such manner, formation of the transfer prevention layer, which is a foreign matter other than the transfer material, on the donor substrate is not preferable in itself since the transfer prevention layer per se may be peeled off and transferred, or impurities may be mixed in the transferring material layer from the transfer prevention layer. In a system in which a transfer material is heated to a comparatively high temperature, like a deposition transfer method in which a light-to-heat conversion layer is formed on a donor substrate and is allowed to absorb light, and then a transfer material is transferred by the generated heat, it was unprecedented that the transfer prevention layer as a foreign matter is irradiated with light so as to positively heat since performances of the device is particularly likely to deteriorate.

However, the present invention enabled high-accuracy patterning for the first time by intentionally irradiating with light so as to simultaneously heat a transferring material layer and a transfer prevention layer on a donor substrate on which the light-to-heat conversion layer is formed. According to such an irradiation method, since a decrease in temperature at the boundary between the transfer prevention layer and transferring material layer is suppressed, it is also possible to transfer a transfer material existing at the boundary by sufficiently heating. Therefore, film thickness distribution of the transfer thin film is uniformized compared with the prior art, and thus enabling suppression of an adverse influence on device performances. It was also found that intensity of light used for transfer can be decreased in the present invention. Therefore, even in case of irradiating with light so that the transferring material layer and transfer prevention layer can be simultaneously heated, it is possible to suppress an adverse influence on device performances caused by exfoliation of a transfer prevention layer, degassing from the transfer prevention layer and the like to a minimum.

Since an attention was paid on the fact that, even if the same energy as in the transfer region was applied by light irradiation, an increase in temperature of the thick and large-volume portion (especially, surface temperature) is suppressed by relatively increase the film thickness of the antitransfer region, the need of selection of a special substance for the light-to-heat conversion layer and transfer prevention layer is relieved and it becomes possible to use more inexpensive laser in the visible and near infrared range, and a support 31 made of a glass substrate, and thus it is advantageous to achieve patterning at low costs.
The present invention will be described in further detail below.

### (1) Irradiation Light

Figs. 4(a) to 4(d) are cross-sectional views showing an example of a method for irradiating a donor substrate with light in the present invention. In Fig. 4(a), a donor substrate 30 is composed of a support 31, a light-to-heat conversion layer 33, a transfer prevention layer 34, and a transferring material layer 37 formed on the whole top surface of the light-to-heat conversion layer 33 and the transfer prevention layer 34, and a device substrate 20 is composed only of a support 21. The donor substrate 30 and the device substrate 20 are arranged so as to face each other. As shown in Fig. 4(b), light typified by laser is incident from the support 31 side of the donor substrate 30, and then the light-to-heat conversion layer 33 is irradiated with light so as to simultaneously heat at least one part of a transfer region and at least one part of an antitransfer region where the transfer prevention layer 34 exists. With such an arrangement, since a decrease in temperature at the boundary between the transfer prevention layer 34 and the transferring material layer 37 is suppressed, it is possible to transfer a transfer material existing at the boundary by sufficiently heating to obtain a uniform transfer film 27. Herein, the transfer film refers to a film obtained by the transfer.

Fig. 4(b) schematically shows a process in which a transferring material layer 37 of a transfer region is heated to vaporize and then accumulated on a support 21 of a device substrate 20 in the form of a transfer film 27. At this point in time, light irradiation can be stopped (light irradiation of this portion is terminated by movement of a light irradiation portion), or the whole right side portion of the transferring material layer 37 can be transferred by continuing light irradiation, followed by transfer of a left side portion. When materials or light irradiation conditions are selected, it is possible to use an ablation mode in which the transferring material layer 37 reaches a support 21 of a device substrate 20 in a state of retaining a film shape. However, from the viewpoint of reducing damage to the material, it is preferred to use a deposition mode in which the transferring material layer 37 is vaporized and transfer in a state of being disentangled into 1 to 100 molecules (atoms).

Fig. 4(c) shows one of preferred aspects of the present invention, in which a light-to-heat conversion layer 33 is irradiated with light having a width larger than that of a transfer region so that the whole width of a transfer region and a part of a transfer prevention layer 34 are simultaneously heated. With such an arrangement, the objective pattern of a transfer film 27 can be efficiently obtained by the fist transfer. Alternatively, the burden to the transferring material layer 37 can be more reduced by transferring the half of a film thickness of the transferring material layer 37 in the transfer region through the first light irradiation and then transferring the remaining half through the second light irradiation.

As shown in Fig. 4(d), even if the position of light irradiation shifts only by "δ" from the position of light irradiation shown in Fig. 4(c), the whole width of the transfer region and a part of the width of the transfer prevention layer 34 are simultaneously heated, similarly, and thus a uniform transfer film 27 can be obtained similarly to the aspect of Fig. 4(c). In a conventional method, only the transfer region is irradiated with light. Therefore, shift of the light irradiation position caused drastic deterioration of uniformity of the transfer film 27. Considering the degree of difficulty of high accuracy alignment of light irradiation over the whole region of the substrate in upsizing, the burden of a light irradiation apparatus is drastically relieved in the method of the present invention.

It is a particularly preferable transfer method that the transferring material layer 37 of the transfer region is dividedly transferred in plural times in a film thickness direction by dividedly irradiating light in plural times to one donor substrate 30. Namely, only a part of transferring material layer 37 is vaporized through single light irradiation by decreasing an intensity of light to be irradiated per one time. Whereby, not only maximum ultimate temperature of the transferring material layer 37, but also maximum ultimate temperature of the transfer prevention layer 34 and the under layer formed on the device substrate 20 are lowered, and thus enabling prevention of damage of the donor substrate and deterioration of performances of the device. In case of performing light irradiation plural times, the number of times is not limited. However, when the number of times is too small, the effect of lowering the temperature is not exerted. In contrast, when the number of times is too large, a harmful effect due to prolonged cumulative heating time is exerted. Therefore, within a range of 5 times or more and 50 times or less are preferably.

As is often seen in display application, in case a set of RGB subpixels is repeated k times in the x direction of the arrangement and repeated h times in the y direction vertical to the direction in one screen, the effect of suppressing material degradation is obtained even by dividedly transferred in plural times (n times) in a film thickness direction in a conventional system of selectively transferring by irradiating only a transfer region corresponding to one pixel with light. However, since the treatment time per one substrate becomes 2 times, productivity drastically deteriorate. However, in the present invention, productivity can be maintained since plural transfer region can be collectively transferred. It is particularly preferred that it is possible to ensure productivity, which is equivalent to or higher than that in a conventional system, by using a wide range of light which satisfies the conditions of m ≥ n, where the symbol m denotes the number of transfer regions to be simultaneously irradiated with light (m is an integer of 2 or more), and the symbol n denotes the number of times of light irradiation (n is an integer of 2 or more). In the production of a display, it is necessary to treat within about 2 minutes per one substrate even in case of a large-scale substrate. On the assumption that a scan speed of laser is normally 0.6 m/second and the side of the substrate is 3 m, the number of times of division (n) is particularly preferably within a range of 15 or more and 30 or less, considering that scan 24 times (12 reciprocations) requires 2 minutes.

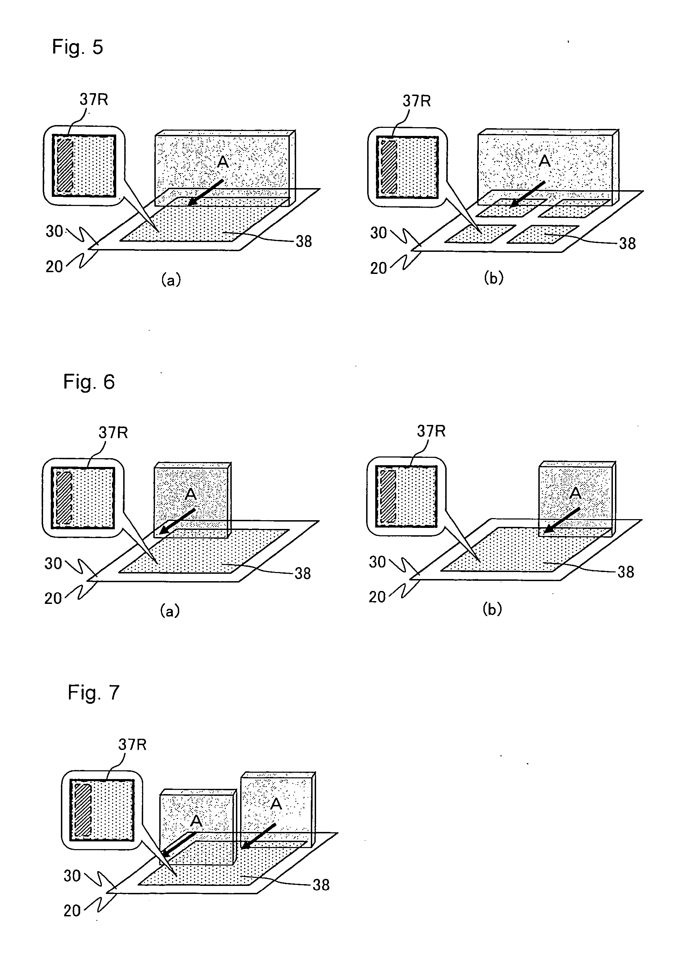

In case of m = k, as shown in Fig. 5(a), it is also possible to'collectively transfer the whole transfer region (37R in the drawing) through single scan by irradiating with light which covers the whole width of a screen 38 of a donor substrate 30. With this arrangement, it is possible to remarkably relieve the burden of alignment of irradiation of the donor substrate 30 with light. As shown in Fig. 5(b), when plural screens 38 exist on the substrate, it is also possible to collectively transfer them. Even in case the respective RGB subpixels are not aligned in a straight line as referred to as a delta-sequence, transfer can be easily carried out since irradiation light can be linearly scanned.

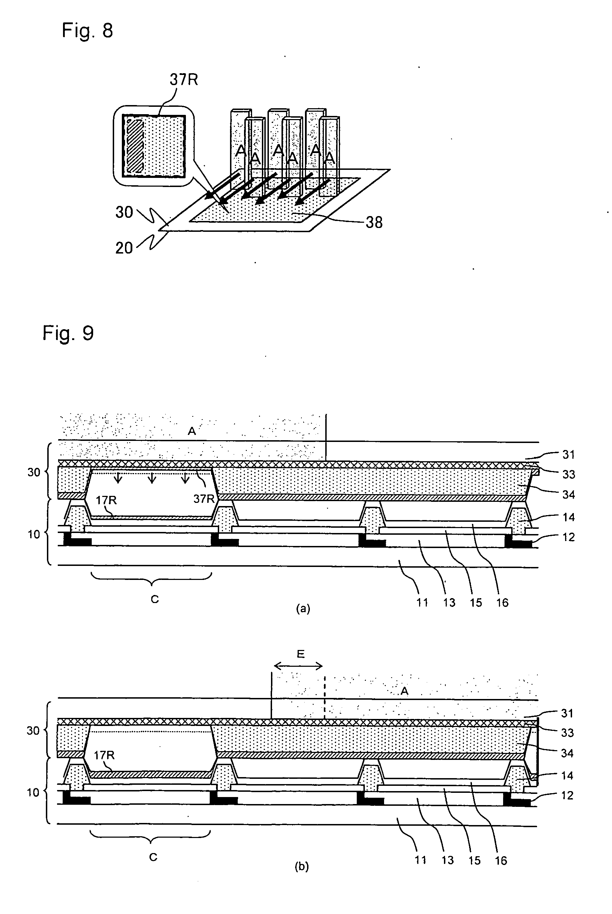

In case of m < k, it is possible to transfer the whole transfer material (37R in the drawing) through scan twice by irradiating with light which covers about the half of the width of a screen 38 of a donor substrate 30 as shown in Fig. 6(a), and then irradiating the remaining half with light as shown in Fig. 6(b). It is also possible to transfer the whole transfer material (37R in the drawing) similarly to the case in Figs. 6(a) and 6(b) by simultaneously scanning two lights in an uneven positional relation in a scan direction as shown in Fig. 7. Even in case it is difficult to obtain one light, which covers the whole width of a screen 38, due to restrictions such as a maximum output of a light source and uniformity of light, it is possible to collectively transfer the whole transfer material similarly to the case in single scan (m = k), spuriously. As a matter of course, as shown in Fig. 8, the similar effect can be obtained by further decreasing the width of light to increase the number.

As shown in Fig. 9(a) and 9(b), it is also possible to mutually overlap the region where light is irradiated plural times. Finally, light may be irradiated over the whole transfer region, and it is possible to select optimum width of irradiation light, order of irradiation, the degree of overlap and the like from various transfer conditions. In case of irradiation with light plural times, light is preferably overlapped at the position of the antitransfer region. In the present invention, it is also possible to arrange plural lights by leaving space at the position of the antitransfer region, to the contrary.

As described previously, a large effect of transfer by a wide range of light lies in that it becomes unnecessary to strictly control the position where light is irradiated as compared with a conventional method. For example, in case of irradiating a donor substrate 30 placed in vacuum with light from a light source placed in atmospheric air, it is impossible to ignore a micro-change in light path caused by a transparent window which separates atmospheric air from vacuum in a conventional method. Therefore, it is necessary to place all of a light source and scan mechanism of light in vacuum, resulting in large burden on the apparatus. On the other hand, since the method of the present invention enables ignorance of the above change in light path, it is possible to simplify not only a light irradiation apparatus, but also mechanism of the entire transfer process apparatus.

Within a scope of irradiation with a wide range of light, thermal diffusion in a cross direction, as a problem of conventional laser transfer, does not occur, and thus it becomes possible to irradiate with light for comparatively long time by scanning laser at comparatively low speed. Therefore, it becomes easier to control maximum ultimate temperature of a transfer material. Since high-accuracy patterning can be performed without causing damage to a transfer material upon transfer, deterioration of performances of the obtained device can be suppressed to a minimum. At the same time, damage to the transfer prevention layer is reduced and thus degradation is less likely to occur even if the transfer prevention layer is formed of an organic material. Therefore, the donor substrate can be recycled plural times and costs required for'patterning can be reduced.

In case the transfer material is a light emitting material of an organic light emitting device, the transfer material is a mixture of a host material and a dopant material, as mentioned below, and it is not unusual that they have temperature characteristics of a different vaporization rate. For example, in case the dopant material has a low vaporization temperature compared with the host material, it is likely to arise such a phenomenon that a dopant material is completely vaporized previously in case of heating at low temperature for a long time. On the other hand, it becomes possible to use a phenomenon called flash vaporization in which a host material and a dopant material are vaporized while remaining substantially the same ratio, in case of heating at high temperature to some extent. In the present invention, it is possible to control not only light irradiation time and light irradiation intensity, but also the number of transfer times. Therefore, it becomes comparatively easy to find out moderate high-speed vaporization conditions analogous to flash vaporization while suppressing material degradation. Therefore, it is possible to realize transfer in which a ratio of a host material to a dopant material does not vary before and after the transfer.

It is also possible to transfer to two device substrates 20 using one donor substrate 30, for example, about the half of a film thickness of a transferring material layer 37 in a transfer region is transferred to a device substrate by single light irradiation, and then the remaining about half of the transferring material layer 37 is transferred to another device substrate by the second light irradiation. It is also possible to transfer one donor substrate to three or more device substrates by adjusting the film thickness of the transferring material layer to be transferred to each device substrate.

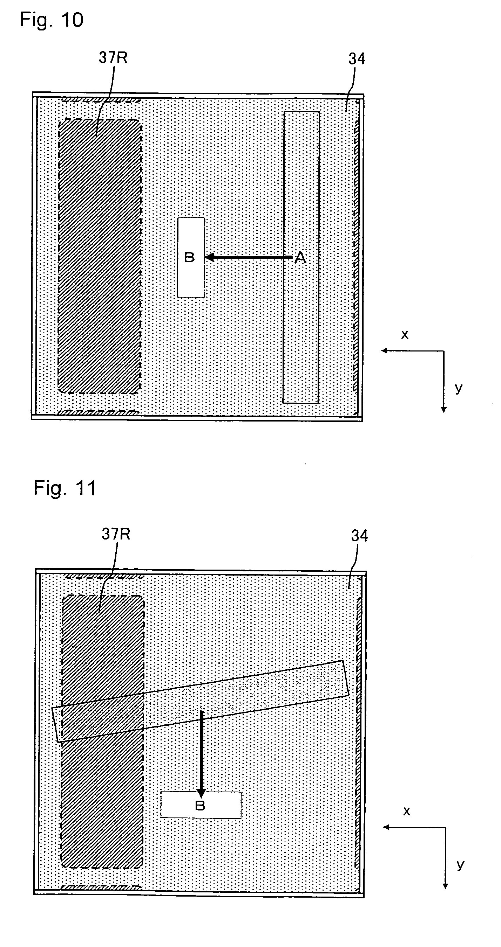

While the example of scanning rectangular light in the y direction was described above, it is also possible to scan in the x direction as shown in Fig. 10. It is not necessary that a scan rate and a light intensity are constant, and the scan rate and light intensity can vary during scanning. The scan direction is preferably an x direction, or a Y direction along a transfer prevention layer 34 and is not particularly limited. It is also possible to scan in an oblique direction.

There is no particular limitation on scan speed, and a scan speed within a range from 0.01 to 2 m/second is preferably used. In case damage to the transfer material is reduced by scanning at comparatively low irradiation intensity of light and lower speed, the scan speed is more preferably 0.6 m/second or less, and still more preferably 0.3 m/second or less. In case an attempt is made to lower the entire temperature by increasing the number of light irradiation times, like the above division transfer, the scan speed is preferably comparatively high speed of 0.3 m/second or more so as to decrease the heat quantity applied per single scan.

It is possible to preferably exemplify, as a light source of irradiation light, laser which is easy to obtain high intensity and is excellent in controllability of the shape of irradiation light. It is also possible to use light sources such as an infrared lamp, a tungsten lamp, a halogen lamp, a xenon lamp and a flash lamp. It is possible to use, as laser, known lasers such as semiconductor laser, fiber laser, YAG laser, argon ion laser, nitrogen laser and excimer laser. Since one of objects of the present invention lies in reduction of damage of the transfer material, continuous wave (CW) laser is preferable compared with intermittent wave (pulse) laser which irradiates high-intensity light within a short time.

There is no particular limitation on the wavelength of irradiation light as long as it is less likely to be absorbed in an irradiation atmosphere and a support of a donor substrate, and is also efficiently absorbed in a light-to-heat conversion layer. Therefore, not only a visible light region, but also an ultraviolet and infrared region can be used. Taking the material of suitable support of the donor substrate into consideration, the wavelength region is preferably from 300 nm to 5 µm, and more preferably from 380 nm to 2 µm.

The shape of irradiation light is not limited to the above-mentioned rectangular shape. According to transfer conditions, optimum shapes such as linear, oval, square and polygonal shapes can be selected. Irradiation light may be formed from plural light sources by superposition. To the contrary, a single light source can also be divided into plural irradiation lights. As shown in Fig. 11, it is possible to scan in the y direction with the arrangement in which rectangular light is obliquely irradiated. In case the shape (width) of irradiation light is fixed, it is possible to cope with transfer having various pitches without requiring large variation of an optical system

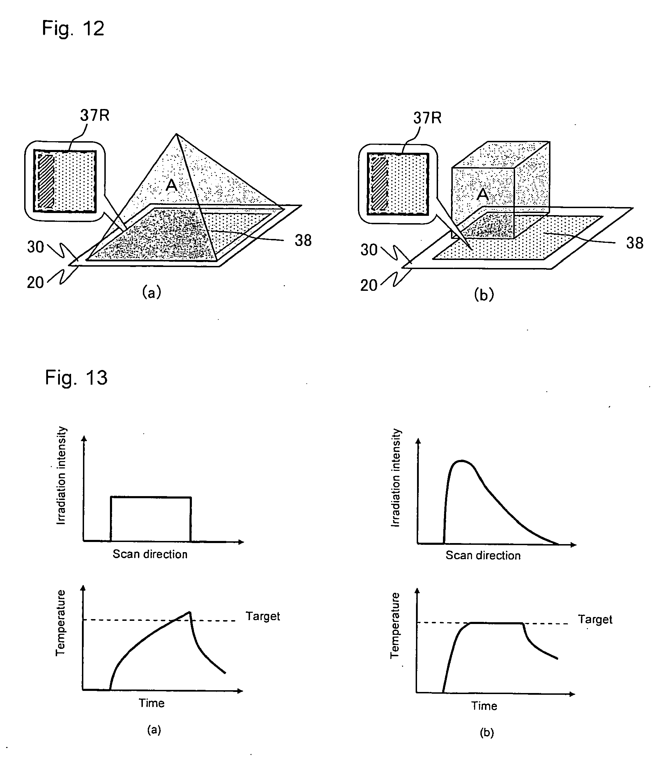

As shown in Fig. 12(a), it is also possible to irradiate with light which covers the whole region of a screen 30 of a donor substrate 30. In this case, it is possible to collectively transfer the whole transfer material without scanning irradiation light. Furthermore, as shown in Fig. 12(b), it is possible to use step irradiation in which light, which partially covers a screen 38 of a donor substrate 30, is irradiated, and then the non-irradiated portion is irradiated. Also in this case, since the front or back position of irradiation light may be overlapped, the burden of alignment of light irradiation can be remarkably relieved.

Preferred range of intensity of irradiation light and heating temperature of the transfer material is influenced by various conditions such as uniformity and irradiation time (scan speed) of irradiation light, support of a donor substrate, material, thickness and reflectance of a substrate and a light-to-heat conversion layer, material and shape of a transfer prevention layer, and material and thickness of a transferring material layer. The aim is to adjust irradiation conditions, for example, density of energy to be absorbed to a light-to-heat conversion layer falls within a range from 0.01 to 10 J/cm² and the transfer material is heated within a range from 220 to 400°C.

Figs. 13(a) and 13(b) are schematic diagrams showing a change in temperature of a transferring material layer (or light-to-heat conversion layer) in case of scan irradiation of light. Although it depends on various conditions, the temperature gradually increases under a given conditions of irradiation intensity, as shown in Fig. 13(a), and it tends to increased even after reaching the target (vaporization temperature). Even under these conditions, it is possible to carry out transfer without causing any problem depending on thickness, heat resistance and irradiation time of the transferring material layer. Examples of preferred irradiation method of more reducing damage to the transfer material include an example in which the irradiation intensity at a certain point is varied with time using irradiation light imparted with intensity distribution so that the temperature becomes constant around at target and also the period is prolonged, as shown in Fig. 13(b). Since capable of reducing damage to the transfer material simultaneously means capable of reducing damage to the transfer prevention layer, the transfer prevention layer does not undergo degradation even in case of forming the transfer prevention layer using a photosensitive organic material, and thus the number of recycle times of a donor substrate can be increased. As shown in Fig. 12, in case of irradiating with light which covers a given range without scanning, similar effect can be obtained by reading "scan direction" in Fig. 13 for "irradiation time".

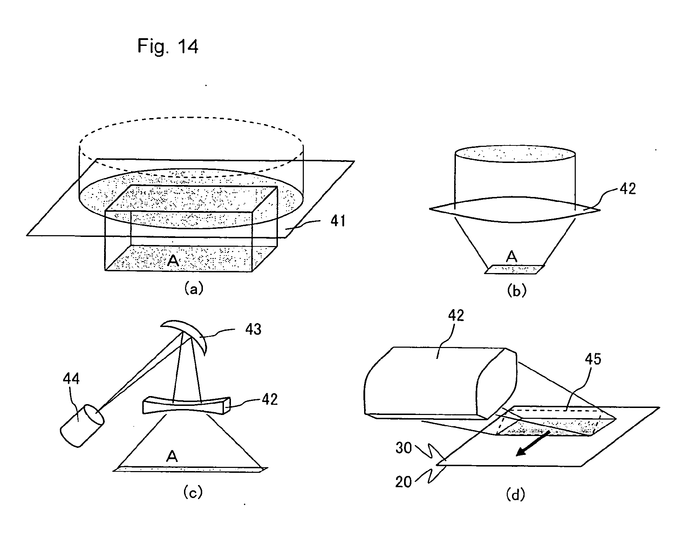

Figs. 14(a) to 14(d) are perspective views showing a method for forming irradiation light. As shown in Fig. 14(a), rectangular irradiation light can be cut out from a circular light bundle by an optical mask 41. In addition to the optical mask 41, a knife edge, an optical interference pattern and the like may be used. As shown in Figs. 14(b) and 14(c), irradiation light can be formed by condensing or extending light from a light source 44 by a lens 42 or a mirror 43. It is also possible to form into irradiation light with any shape by appropriately using the above-mentioned optical mask 41, lens 42, mirror 43 and the like in combination. It is also possible to design so that rectangular irradiation light has uniform irradiation intensity in a major axial direction and also has Gaussian distribution in a minor axial direction.

Fig. 14(d) shows an example which realizes time dependency of an irradiation intensity shown in Fig. 13(b). Irradiation light is obliquely condensed to a surface of a donor substrate 30 through a lens 42. When arranged so that the near side of a virtual focal plane 45 indicated by the broken line generally agrees with a light-to-heat conversion layer (not shown) of a donor substrate 30, the near side becomes the on-focus condition which agrees with a focusing distance of the lens 42, and thus the irradiation density becomes maximum. Since the far side becomes the off-focus condition which deviates from the focusing distance, and thus the irradiation density decreases. With such arrangement, in case of scanning irradiation light from the back side toward the near side, it is possible to obtain time dependency of the irradiation intensity, which is conceptually shown in Fig. 13(b).

### (2) Donor Substrate

The donor substrate of the present invention includes a support, a light-to-heat conversion layer, a transfer prevention layer and a transferring material layer. The light-to-heat conversion layer and the transfer prevention layer are formed on the support, and the transferring material layer is formed on a top surface of the light-to-heat conversion layer and the transfer prevention layer. A transfer region and an antitransfer region are formed by combinations of the light-to-heat conversion layer and the transfer prevention layer. Namely, the portion where the transfer prevention layer is formed would serve as an antitransfer region, while the portion where the transfer prevention layer is not formed and only the light-to-heat conversion layer exists would serve as a transfer region. Herein, the transferring material layer is formed on the whole surface of the transfer region, and at least one part of the antitransfer region.

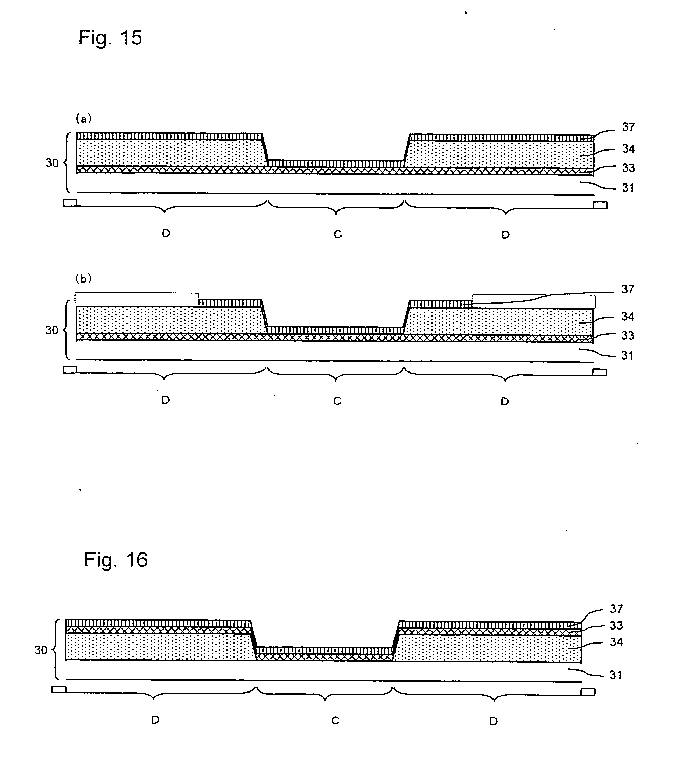

Typical configurations of the donor substrate 30 of the present invention are shown in Figs. 15(a) and 15(b). Fig. 15(a) shows the same configuration as shown in Fig. 2, in which a light-to-heat conversion layer 33 is formed on almost the whole surface of a support 31; a transfer prevention layer 34 is pattern-formed on the light-to-heat conversion layer 33; and a transferring material layer 37 is formed on almost the whole top surface of the light-to-heat conversion layer 33 and the transfer prevention layer 34. Herein, "formed on almost the whole surface" means that the layer is formed on the whole surface of the donor substrate 30 in principle, and may not be necessarily formed in the peripheral portion of the donor substrate which is not involved in patterning. Also, "pattern-formed" means that the layer is formed only in the antitransfer region D on the donor substrate 30. The region where the transfer prevention layer 34 is not formed would serve as a transfer region C. In case of uniformly irradiating the light-to-heat conversion layer 33 with light through the support 31, the light-to-heat conversion layer 33 is momentarily heated to high temperature. In the transfer region, the light-to-heat conversion layer 33 is in contact with the transferring material layer 37, and thus the transfer material is heated to the temperature required for vaporization. On the other hand, in the antitransfer region, comparatively thick transfer prevention layer 34 is formed between the light-to-heat conversion layer 33 and the transferring material layer 37. Therefore, even if the light-to-heat conversion layer 33 is heated, the transfer material is not heated to the temperature required for deposition, thus the transfer material remains adhered onto the transfer prevention layer 34.

In such way, since the transfer material in the antitransfer region is not transferred, it is not necessarily required that the transferring material layer is formed on the whole surface in the antitransfer region and, for example, it may be formed at least one part of the antitransfer region, as shown in Fig. 15(b). The transferring material layer in the antitransfer region is not necessarily required for transfer of the transfer material. However, there is an advantage that accuracy for selective formation only in the transfer region is not required in case of forming the transferring material layer with the configuration in which the transferring material layer is formed at least one part of the antitransfer region. For example, in case of directly patterning emitting layers 17R, 17G and 17B of an organic light emitting device 10 shown in Fig. 1 by a mask deposition method, it is required for a deposition mask to sufficiently expose the desired emitting layer-forming region and to completely mask adjacent emitting layer-forming region with another color. Therefore, an error permissible to the portion, where apertural areas are formed, of the deposition mask is a width of an insulating layer 14 at most. On the other hand, in case of patterning a transferring material layer 37 of a donor substrate 30 of the present invention shown in Fig. 15(b) by a mask deposition method, it is required for a deposition mask to sufficiently expose a transfer region, and thus an error permissible to the portion, where apertural areas are formed, of the deposition mask is remarkably relieved. Particularly, in case of forming a transferring material layer on almost the whole top surface of a light-to-heat conversion layer and a transfer prevention layer, labor required to form a pattern is omitted.

Another example of the configuration of a donor substrate 30 of the present invention is shown in Fig. 16. Herein, a transfer prevention layer 34 is pattern-formed first on a support 31 using a substance which is not completely transparent to light (with light absorption characteristics and/or light reflection characteristics); a light-to-heat conversion layer 33 is formed on almost the whole surface of the support 31 and the transfer prevention layer 34; and a transferring material layer 37 is formed on almost the whole top surface of the light-to-heat conversion layer 33. In case of uniformly irradiating through the support 31, the light-to-heat conversion layer 33 in the transfer region is momentarily heated to high temperature and the transferring material layer 37 in contact with the light-to-heat conversion layer 33 is heated to the temperature required for vaporization. On the other hand, since light is at least partially absorbed or reflected by the transfer prevention layer 34 in the antitransfer region, the intensity of light reaching the light-to-heat conversion layer 33 decreases to that in the transfer region and thus the transferring material layer 37 is not heated to the temperature required for deposition. Therefore, the transfer material remains adhered onto the light-to-heat conversion layer 33.

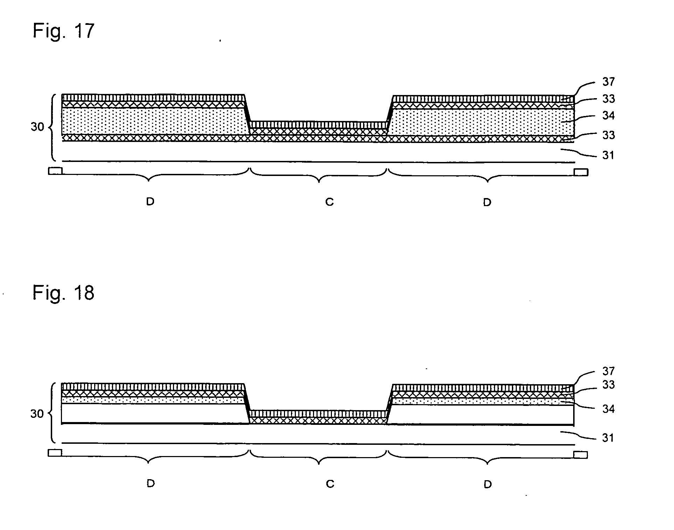

The structure of the donor substrate of the present invention is not limited to the above example as long as a transfer region and an antitransfer region are formed by combinations of a light-to-heat conversion layer and a transfer prevention layer. For example, as shown in Fig. 17, the structure may be a structure in which a pattern-formed transfer prevention layer 34 is sandwiched between two light-to-heat conversion layers 33 formed on almost the whole surface. For example, it is possible to exemplify, as preferred configuration in the present invention, the donor substrate 30 in which a stable inorganic material such as high-melting-point metal capable of mixing of impurities in the transferring material layer 37 and suppressing degradation upon vaporization is used in the light-to-heat conversion layer 33 as a top surface and an organic material having excellent patterning properties and film thickening is used in the transfer prevention layer 34, since the donor substrate is less likely to exert an adverse influence on the transferring material layer 37 upon the transfer and can be realized by comparatively easy process.

Alternatively, as shown in Fig. 18, the support 31 per se may be subjected to irregularity processing; a transfer prevention layer 34 may be formed on a top surface of protrusion of a support 31; and a light-to-heat conversion layer 33 may be formed on almost the whole top surface. An etching method can be used in irregularity processing of the support 31. It is also possible to form a transfer prevention layer 34 by introducing a light scattering function on a top surface or the inside of protrusion by a known technique.

In the donor substrate of the present invention, it is particularly preferred that the portion in contact with the transferring material layer is made of an inorganic substance from the viewpoint of cleaning resistance for recycling and a reduction in mixing of impurities upon the transfer. Although the transferring material layer of the donor substrate shown in Figs. 16 to 18 is in contact with the light-to-heat conversion layer, the material of the light-to-heat conversion layer is preferably an inorganic substance, as mentioned below, and thus such a donor substrate is a particularly preferable aspect of the present invention. The transferring material layer of the donor substrate shown in Fig. 15 is in contact with the transfer prevention layer in an antitransfer region. The material of the transfer prevention layer may be either an organic substance or an inorganic surface, as mentioned below. From the above point of view, when the transfer prevention layer is made of an inorganic substance, such a donor substrate is a particularly preferable aspect of the present invention. When the transfer prevention layer is composed of plural layers, at least the outermost surface layer in contact with the transferring material layer is preferably made of an inorganic substance.

The material of the support of the donor substrate is not particularly limited as long as it is a material which has less light absorptivity and is also capable of stably forming a light-to-heat conversion layer, a transfer prevention layer and a transferring material layer. A resin film can be used depending on the conditions. Examples of the material of the resin film include polyester, polyethylene, polyethylene terephthalate, polyethylene naphthalate, polycarbonate, polyacryl, polysulfone, polyethersulfone, polyphenylene sulfide, polyimide, polyamide, polybenzoxazole, polyepoxy, polypropylene, polyolefin, aramid resin, silicone resin and the like.

Examples of the support, which is preferable from the viewpoint of chemical stability, thermal stability, dimensional stability, mechanical strength and transparency, include a glass plate. The material of the glass plate can be selected from soda-lime glass, alkali-free glass, lead glass, borosilicate glass, aluminosilicate glass, low expansion glass, quartz glass and the like according to the conditions. In case of carrying out the transfer process of the present invention in vacuum, it is required for a gas to be release from the support in a small amount, and thus the glass plate is particularly preferable support.

Even if the light-to-heat conversion layer is heated to high temperature, it is necessary for temperature rise (thermal expansion) of the support per se to fall within a permissible range. Therefore, it is preferred that heat capacity of the support is sufficiently larger than that of the light-to-heat conversion layer. Accordingly, the thickness of the support is preferably 10 or more times larger than that of the light-to-heat conversion layer. The permissible range depends on size of transfer region and required accuracy of patterning. For example, in case the temperature of the light-to-heat conversion layer raises by 300°C from room temperature and it is required to suppress temperature rise of the support per se in case of heating the support by thermal diffusion to 3°C or lower, which is 1/100 of temperature rise of the light-to-heat conversion layer, and also volumetric heat capacity of the light-to-heat conversion layer is nearly the same as that of the support, the thickness of the support is preferably 100 or more times larger than that of the light-to-heat conversion layer. In case it is required to suppress temperature rise of the support per se to 1°C or lower, which is 1/300 of temperature rise of the light-to-heat conversion layer, the thickness of the support is more preferably 300 or more times larger than that of the light-to-heat conversion layer. In case volumetric heat capacity of the light-to-heat conversion layer is around two times lager than that of the support, the thickness of the support is preferably 200 or more times, and more preferably 600 or more times, larger than that of the light-to-heat conversion layer. Whereby, a dimensional change due to thermal expansion decreases even if the substrate is upsized, and thus enabling high-accuracy patterning.

The light-to-heat conversion layer is not particularly limited as long as it efficiently absorbs light to generate heat, and also includes a stable material and configuration to the thus generated heat. Examples of usable light-to-heat conversion layer include thin films in which carbon black, graphite, titanium black, organic pigment, metal particles and the like are dispersed in a resin. It is also possible to use, as the light-to-heat conversion layer, inorganic thin films such as metal thin films. In the present invention, since the light-to-heat conversion layer is sometimes heated to about 300°C, the light-to-heat conversion layer is preferably composed of an inorganic thin film having excellent heat resistance. From the viewpoint of light absorption and film forming properties, it is particularly preferably composed of a metal thin film. It is possible to use, as the metallic material, thin films made of simple substances such as tungsten, tantalum, molybdenum, titanium, chromium, gold, silver, copper, platinum, iron, zinc, aluminum, cobalt, nickel, magnesium, vanadium, zirconium, silicon and carbon, and alloys thereof, and stacked thin films thereof. From the viewpoint of stability, tantalum can be exemplified as particularly excellent light-to-heat conversion material.

An antireflection layer can be optionally formed on the support side of the light-to-heat conversion layer in the transfer region. Furthermore, an antireflection layer may be formed on a surface of a light incident side of the support. An optical interference thin film using a difference in refractive index is suitably used as the antireflection layer, and it is possible to use thin films made of simple substances such as silicone, silicon oxide, silicon nitride, zinc oxide, magnesium oxide and titanium oxide, and mixtures thereof, and stacked thin films thereof.

A light reflection layer can be optionally formed on the support side of the light-to-heat conversion layer or transfer prevention layer in the antitransfer region. The light reflection layer can also be formed as the transfer prevention layer per se. A metal thin film and the above optical interference thin film are suitably used as the light reflection layer.

A transfer aid layer can be optionally formed on the transferring material layer side of the light-to-heat conversion layer in.the transfer region. An example of functions of the transfer aid layer is a function capable of preventing degradation of the transfer material by a catalytic effect of the heated light-to-heat conversion layer. It is possible to use, as the transfer aid layer, thin films made of inactive inorganic substances, for example, metals such as tungsten, tantalum, molybdenum and silicone, and oxides or nitrides thereof. Another example of the function of the transfer aid layer is a surface modification function in case of forming the transferring material layer by a coating method. It is possible to use a rough-surface thin films made of the above-mentioned inactive inorganic substances, and porous films of metal oxides. Still another example of the function of the transfer aid layer is a heating uniformization of the transferring material layer. In order to uniformly heating comparatively thick transferring material layer, it is possible to form a transfer aid layer having a spike-shaped (or porous) structure using a material such as metal having excellent thermal conductivity and to arrange a transferring material layer between gaps so as to support the layer. The transfer aid layer having this function may be integrated with the light-to-heat conversion layer.

It is necessary for the light-to-heat conversion layer to apply sufficient heat to the transferring material layer, and thus heat capacity of the light-to-heat conversion layer in the transfer region is preferably larger than that of the transferring material layer. Therefore, the thickness of the light-to-heat conversion layer is preferably larger than that of the transfer material, and more preferably 5 or more times larger than that of the transferring material layer. Specifically, the thickness of the light-to-heat conversion layer is preferably from 0.02 to 2 µm, and more preferably from 0.1 to 1 µm. Since the light-to-heat conversion layer preferably absorbs 90% or more, and more preferably 95% or more, of irradiation light, it is preferred to design the thickness of the light-to-heat conversion layer so as to satisfy these conditions. In case of forming a transfer aid layer, it is preferred to design so that the transfer aid layer becomes thin within a range of satisfying required functions so as not to disturb efficient transfer of heat generated in the light-to-heat conversion layer to the transferring material layer.

It is possible to use, as the method for forming the light-to-heat conversion layer or transfer aid layer, known technologies such as spin coating, slit coating, vacuum vapor-deposition, EB vapor-deposition, sputtering and ion plating according to materials. In case of patterning, a known photolithography method, laser ablation and the like can be used.

The planar shape of the light-to-heat conversion layer is not particularly limited as long as it is formed in the transfer region. As exemplified above, it may be formed on almost the whole surface of the donor substrate, or may be patterned.

The transfer prevention layer is not particularly limited as long as it includes a stable material and configuration to heat generated in the light-to-heat conversion layer or direct light irradiation to the transfer prevention layer. Examples of the material of the transfer prevention layer include inorganic substances, for example, metals, metal oxides such as silicon oxide and silicon nitride, metal nitride, glass and ceramics; and organic substances, for example, resins such as polyvinyl, polyimide, polybenzoxazole, polystyrene, acryl, novolak and silicone. For example, a glass paste material used in partition walls of plasma televisions can also be used in formation of the transfer prevention layer of the present invention. The materials having excellent patterning properties, film thickening and heat insulating properties are preferably organic materials such as polyimide and polybenzoxazole. The materials having excellent durability, surface cleanliness and thermal diffusion are preferably inorganic materials such as metals and metal oxides.

There is no particular limitation on the method for forming a transfer prevention layer. In case of using an inorganic substance, known technologies such as vacuum vapor-deposition, EB vapor-deposition, sputtering, ion plating, CVD, laser ablation and electroforming can be used. In case of using an organic substance, known technologies such as spin coating, slip coating and dip coating can be used. There is no particular limitation on the method for patterning a transfer prevention layer. For example, a known photolithography method, electroforming and the like can be used. The transfer prevention layer may be patterned by an etching (or lift-off) method using a photoresist. It is also possible to pattern by directly exposing a transfer prevention layer using a photosensitive resin material, followed by developing. It is also possible to use a stamp method or inprint method in which a mold is pressed against a transfer prevention layer formed on the whole surface, an ink-jet method or nozzle-jet method in which a resin material is directly pattern-formed, various printing methods and the like.

The planar shape of the transfer prevention layer may be, for example, a lattice-shaped structure or a stripe-shaped structure extending in the y direction. There is no particular limitation on the thickness of the transfer prevention layer. The transfer prevention layer preferably has a larger heat capacity than that of the light-to-heat conversion layer, considering that it has a function capable of suppressing temperature rise compared with the transfer region. Therefore, the thickness of the transfer prevention layer is preferably larger than that of the light-to-heat conversion layer, and more preferably 5 or more times larger than that of the light-to-heat conversion layer. Specifically, the thickness of the transfer prevention layer is preferably from 1 to 100 µm, and more preferably from 2 to 20 µm.

When the donor substrate and the device substrate are arranged so as to face each other, it is preferred that the transferring material layer of the donor substrate is not in direct contact with the surface to be transferred of the device substrate. In that case, the distance between the transferring material layer of the donor substrate and the surface to be transferred of the device substrate is preferably maintained within a range from 1 to 100 µm, and more preferably from 2 to 20 µm. Therefore, the thickness of the antitransfer region in the donor substrate is preferably larger than that of the transfer region, and more preferably 5 or more times larger than that of the transfer region. Specifically, the thickness of the antitransfer region is preferably from 1 to 100 µm, and more preferably from 2 to 20 µm. Herein, the thickness of the transfer region is defined as the total thickness of all layers except for a support and a transferring material layer among layers included from the support to the transferring material layer of the donor substrate in a transfer region. The thickness of the antitransfer region is similarly defined as the total thickness of all layers except for a support and a transferring material layer among layers included from the support to the transferring material layer of the donor substrate in an antitransfer region, when the support had a flat surface. In case there is a difference in thickness of the support in a transfer region and an antitransfer region, as shown in Fig. 18, the thickness of the antitransfer region is defined as the thickness of the antitransfer region using the support surface in the transfer region as a standard surface, provided that the transferring material layer is excluded. It becomes easier to maintain the distance between the transferring material layer of the donor substrate and the surface to be transferred of the device substrate at a given value by making the donor substrate including an antitransfer region having such a thickness and the device substrate to face each other, and it is also possible to reduce possibility of penetration of the vaporized transfer material into the other compartment.

The cross-sectional shape of the transfer prevention layer is preferably a forward tapered shape so as to facilitate uniform accumulation of the vaporized transfer material on the device substrate. When a pattern like the insulating layer 14 exists on the device substrate 10, as shown in Fig. 2, the width of the transfer region C is preferably larger than that between adjacent insulating layers. In case of alignment, it is preferred to arrange so that the width between adjacent insulating layers falls within the width of the transfer region C. In this case, even if the transfer prevention layer 34 is thin, the distance between the donor substrate 30 and device substrate 10 can be maintained at the desired distance by thickening the insulating layer 14. Typical width of the transfer region C is from 10 to 200 µm, and the pitch is form 30 to 600 µm, and they may be designed to optimum value according to applications and are not particularly limited.

Before forming the transferring material layer on almost the whole top surface, the surface of the light-to-heat conversion layer and transfer prevention layer can be cleaned using known technologies such as a plasma treatment and a UV-ozone treatment, including a conventional wet cleaning.

### (3) Transfer Material

The transfer material is a material which forms a thin film constituting devices such as organic TFTs, photoelectric transducers and various sensors, including organic light emitting devices. The transfer material may be either an organic material, or an inorganic material including metals, and may be a material which can be transferred a donor substrate to a device substrate using vaporization, sublimation, ablation sublimation, change in adhesion or change in volume in case of being heated. The transfer material may be a precursor of a thin film-forming material, or may be converted into a thin film-forming material by heat or light before or during the transfer to form a transfer film.

The thickness of the transferring material layer in the donor substrate varies depending on functions thereof and the number of transfer times. For example, in case of transferring a donor material (electron injection material) such as lithium fluoride, the thickness of the transferring material layer is sufficiently 1 nm. In case of an electrode material, the thickness of the transferring material layer may be sometimes 100 nm or more. In case of an emitting layer of an organic light emitting device as suitable application of the present invention, the thickness of the transferring material layer is preferably from 10 to 100 nm, and more preferably from 20 to 50 nm.

There is no particular limitation on the method for forming a transferring material layer. The method, which is easy to cope with upsizing and is advantageous for achieving low cost, is preferably a method in which a solution composed of at least a transfer material and a solvent is applied and then the solvent is removed by drying. Examples of the coating method include an ink-jet coating method, a nozzle coating method, and an electrolytic polymerization or electrodeposition method, and various printing methods such as an offset printing method, a flexo printing method, a lithographic printing method, a relief printing method, a gravure printing method and a screen printing method. It is also possible to use, as the method which causes less mixing of impurities in forming a transferring material layer and is advantageous in film thickness uniformity, dry processes such as vacuum vapor-deposition and sputtering. When high purity is required, like an emitting layer of an organic light emitting device, and a transfer material in an antitransfer region is recovered and recycled, the dry process is preferably used for the purpose of mainly preventing mixing of impurities in the transfer material.

### (4) Device Substrate

There is no particular limitation on the support used in the device substrate, and materials exemplified in the donor substrate can be used. In order to prevent deterioration of patterning accuracy caused by a difference in thermal expansion due to a change in temperature in case of transferring a transfer material by making a device substrate and a donor substrate to face each other, a difference in thermal expansion coefficient between a device substrate and a support of a donor substrate is preferably 10 ppm/°C or lower. Therefore, the support of both substrates is more preferably made of the same material. It is also possible to exemplify the glass plate, exemplified as particularly preferable support of the donor substrate, as particularly preferable support of the device substrate. The thickness of the support of both substrates may be the same or different.

The device substrate may be composed only of a support before the transfer. However, it is usual to form a structure required for the configuration of the device on the support in advance. For example, in the organic light emitting device shown in Fig. 1, an insulating layer 14 and a hole transporting layer 16 are formed on a support 11 by the prior art, and then the obtained product can be used as a device substrate.

The structure like the above insulating layer is not indispensable. However, it is preferred to form an insulating layer on a device substrate in advance from the viewpoint of preventing an antitransfer region of a donor substrate from being scratched through contact with an under layer, which has been formed on a device substrate, in case of making the device substrate and donor substrate to face each other. It is possible to use materials, film forming methods and patterning methods, exemplified in formation of a transfer prevention layer of the donor substrate, for formation of an insulating layer. With respect to shape, thickness, width and pitch of the insulating layer, shapes and numerical values, exemplified in formation of the transfer prevention layer of the donor substrate, can be exemplified.

### (5) Transfer Process

As an example of the transfer process, a donor substrate and a device substrate made to face each other in vacuum, and then extraction in atmospheric air and transfer can be carried out in a state where the transfer space is maintained in vacuum. For example, the region surrounded by them can be maintained in vacuum using a transfer prevention layer of a donor substrate and/or an insulating layer of a device substrate. In this case, a vacuum sealing function may be provided at the peripheral portion of a donor substrate and/or a device substrate. In case an under layer of the device substrate, for example, a hole transporting layer is formed by a vacuum process, an emitting layer is formed by the patterning method of the present invention, and an electron transporting layer is formed by a vacuum process, it is preferred to face a donor substrate and a device substrate each other in vacuum, and transfer is carried out in vacuum. In this case, it is possible to use, as the method in which a donor substrate and a device substrate are aligned with high accuracy in vacuum and a facing state is maintained, known technologies such as steps of dropwise addition of a liquid crystal material in vacuum and lamination used in the production process of a liquid crystal display. It is also possible to subject a donor substrate to a heat release or cooling operation upon the transfer regardless of a transfer atmosphere. In case of recycling a donor substrate, the donor substrate can also be used as an endless belt. In case of using a light-to-heat conversion layer formed of a good conductor such as metal, a donor substrate can be easily maintained by an electrostatic method.

In the present invention, since transfer in a vapor deposition mode is preferred, it is preferred to transfer a single-layered transferring material layer in single transfer. However, a stacked structure of electron transporting layer/emitting layer is formed as a transferring material layer on a donor substrate in advance using a peel-off mode or an ablation mode, and then the transferring material layer of emitting layer/electron transporting layer can also be transferred at a time by transferring to a device substrate in a state where a stacked structure is maintained.

The transfer atmosphere may be either an atmospheric pressure or reduced pressure. For example, in case of reactive transfer, transfer can also be carried out in the presence of an active gas such as oxygen. In the present invention, since reduction of damage of a transfer material in the transfer step is one of objects, the atmosphere is preferably an inert gas atmosphere such as a nitrogen gas atmosphere, or under vacuum. It is possible to promote uniformization of film thickness unevenness upon the transfer by moderately controlling a pressure of a transfer atmosphere. From the viewpoint of reduction of damage of a transfer material, reduction of mixing of impurities in a transfer film and lowering of a vaporization temperature, the transfer atmosphere is particularly preferably under vacuum.

One of problems of a conventional method in which a thin film formed by a coating method is directly used as a function layer of an organic light emitting device was film thickness unevenness. In the present invention, equivalent film thickness unevenness can be generated at the point in time when a transferring material layer was formed by a coating method. However, in a deposition mode as a preferable transfer system in the present invention, since a transfer material is accumulated on a device substrate after vaporizing in a state of being disentangled into molecules (atoms) upon the transfer, film thickness unevenness of the transfer film is relieved. Therefore, the transfer material is in the form of particles composed of a molecular assembly, like a pigment, upon application and, even if the transferring material layer is not a continuous film on a donor substrate, a transfer film excellent in film thickness uniformity can be obtained on a device substrate by disentangling into a molecular level upon the transfer, followed by vaporization and further accumulation.

The method for producing a device using a patterning method of the present invention will be described below. In the present invention, the device refers to organic light emitting devices, organic TFTs, photoelectric transducers and various sensors. In the organic TFT, an organic semiconductor layer, an insulating layer, and various electrodes such as source, drain and gate electrodes can be patterned by the present invention. In the photoelectric transducer, electrodes can be patterned by the present invention. In the sensor, a sensing layer and electrodes can be patterned by the present invention. The method for producing an organic light emitting device will be described below by way of the organic light emitting device as an example.

Fig. 1 is a sectional view showing a typical structure of an organic light emitting device 10 (display). On a support 11, an active matrix circuit composed of TFT 12 and a planarizing layer 13 is formed. A light emitting device portion is first electrode 15/hole transporting layer 16/emitting layer 17/electron transporting layer 18/second electrode 19 formed thereon. At the end of a first electrode, an insulating layer 14 for preventing the occurrence of short circuit at the end of the electrode and defining an emitting region is formed. The configuration of the light emitting device is not limited to this example. For example, only one emitting layer having both a hole transporting function and an electron transporting function may be formed between a first electrode and a second electrode. The hole transporting layer may be a stacked structure of plural layers of a hole injection layer and a hole transporting layer. The electron transporting layer may be a stacked structure of plural layers of an electron transporting layer and an electron injection layer. When the emitting layer has an electron transporting function, the electron transporting layer may be omitted. The respective layers may be stacked in order of first electrode/electron transporting layer/emitting layer/hole transporting layer/second electrode. Each of these layers may be composed of either a single layer or plural layers. After formation of a second electrode, formation of a protective layer, formation of a color filter and sealing may be performed using known technologies or the patterning method of the present invention (not show).

In a color display, it is necessary to pattern at least an emitting layer, and the patterning method of the present invention is suitably applied to patterning of an emitting layer. The insulating layer, first electrode, TFT and the like are often patterned by a known photolithography method, or may be patterned by the patterning method of the present invention. In case of requiring patterning of at least one layer of the hole transporting layer, electron transporting layer and second electrode, patterning may be performed by the patterning method of the present invention. After patterning only R and G emitting layers by the present invention, a B emitting layer and a layer serving both R and G electron transporting layers can also be formed on the whole surface of the emitting layer.

As an example of production of the organic light emitting device shown in Fig. 1, layers up to a first electrode 15 are formed using a photolithography method and an insulating layer 14 is patterned by a known technology using a photosensitive polyimide precursor material, and then a hole transporting layer 16 is formed on the whole surface by a vacuum deposition method. Using this hole transporting layer 16 as an under layer, emitting layers 17R, 17G and 17B are formed thereon by the patterning method of the present invention shown in Fig. 2. When an electron transporting layer 18 and a second electrode 19 are formed on the whole surface of the emitting layer by a known technology using a vacuum deposition method, an organic light emitting device can be completed.

The emitting layer may be composed of either a single layer or plural layers, and the light emitting material of each layer may be either a single material or a mixture of plural materials. From the viewpoint of emission efficiency, purity and durability, the emitting layer is preferably a single-layered structure of a mixture of a host material and a dopant material. Therefore, the transfer material, which forms the emitting layer, is preferably a mixture of a host material and a dopant material.

In case of forming a transferring material layer on a donor substrate using a coating method, the transferring material layer can be formed by applying a mixed solution of a host material and a dopant material, followed by drying. A solution of a host material and a solution of a dopant material may be separately applied. Even if the host material and the dopant material are not uniformly mixed at the stage of forming a transferring material layer, both may be uniformly mixed upon the transfer. Utilizing a difference in vaporization temperature between the host material and dopant material upon the transfer, the concentration of the dopant material in the emitting layer can also be varied in a film thickness direction.

Examples of the material of the emitting layer include anthracene derivatives, tetracene derivatives, pyrene derivatives, various metal complexes including quinolinol complexes such as tris(8-quinolinolate)aluminum (Alq₃), and benzothiazolylphenol zinc complexes, bisstyrylanthracene derivatives, tetraphenylbutadiene derivatives, cumarin derivatives, oxadiazole derivatives, benzoxazole derivatives, carbazole derivatives, distyrylbenzene derivatives, pyrrolopyridine derivatives, perinone derivatives, cyclopentadiene derivatives, oxadiazole derivatives, thiadiazolopyridine derivatives, rubrene, quinacridone derivatives, phenoxazone derivatives, perinone derivatives, perylene derivatives, cumarin derivatives, chrysene derivatives, pyrromethene derivatives, low-molecular-weight materials such as iridium complex-based material called phosphorescent materials, and high-molecular-weight materials including polyphenylenevinylene derivatives, polyparaphenylene derivatives and polythiophene derivatives. Examples of the material, which is particularly excellent in light emitting performances and is suited for the patterning method of the present invention, include anthracene derivatives, naphthacene derivatives, pyrene derivatives, chrysene derivatives, pyrromethene derivatives and various phosphorescent materials.

The hole transporting layer may be composed of either a single layer or plural layers, and each layer may be made of either a single material or a mixture of plural materials. The layer called the hole injection layer is also included in the hole transporting layer. From the viewpoint of hole transporting properties (low driving voltage) and durability, an acceptor material for enhancement of the hole transportability may be mixed in the hole transporting layer. Therefore, the transferring material layer, which forms the hole transporting layer, may be composed either a single material or a mixture of plural materials. In case of forming a transferring material layer on a donor substrate, the transferring material layer can be formed by various techniques similar to the emitting layer.

Examples of the material of the hole transporting layer include low-molecular-weight materials such as aromatic amines typified by N,N'-diphenyl-N,N'-dinaphthyl-1,1'-diphenyl-4,4'-diamine (NPD), N,N'-biphenyl-N,N'-biphenyl-1,1'-diphenyl-4,4'-diamine and N,N'-diphenyl-N,N'-(N-phenylcarbazolyl)-1,1'-diphenyl-4,4'-diamine, N-isopropyl carbazol, pyrazoline derivatives, stilbene-based compounds, hydrazone-based compounds, and heterocyclic compounds typified by oxadiazole derivatives and phthalocyanine derivatives; and high-molecular-weight materials such as polycarbonates, styrene derivatives, polyvinyl carbazoles and polysilanes having these low-molecular-weight compounds in their side chains. Examples of the acceptor material include low-molecular-weight materials such as 7,7,8,8-tetra-cyanoquinodimethane (TCNQ), and hexaazatriphenylene (HAT) and cyano group derivatives thereof (HAT-CN6). Further examples of the hole transporting materials and the acceptor materials include metal oxides such as molybdenum oxide and silicon oxide thinly formed on the surface of the first electrode.

The electron transporting layer may be composed of either a single layer or plural layers, and each layer may be made of either a single material or a mixture of plural materials. The layers called the hole blocking layer and the electron injection layer are also included in the electron transporting layer. From the viewpoint of the electron mobility (low driving voltage) and durability, a donor material for enhancement of the electron mobility may be mixed in the electron transporting layer. The layer called the electron injection layer is often regarded as the donor material. The transfer material which forms the electron transporting layer may be made of either a single material or a mixture of plural materials. In case of arranging a transferring material on a donor substrate, the transferring material layer can be formed by various techniques similar to the emitting layer.

Examples of the material of the electron transporting layer include low-molecular-weight materials such as quinolinol complexes including Alq₃ and 8-quinolinolato lithium (Liq), condensed aromatic derivatives including naphthalene and anthracene, styryl aromatic ring derivatives represented by 4,4'-bis(diphenylethenyl)biphenyl, quinone derivatives including anthraquinone and diphenoquinone, phosphorus oxide derivatives, benzoquinolinol complexes, hydroxyazole complexes, azomethine complexes, various metal complexes including tropolone metal complexes and flavonol metal complexes, and compounds having heteroaryl ring structures containing electron-accepting nitrogen; and high-molecular-weight materials having these low-molecular-weight compounds in their side chains.

Examples of the donor material include various metal complexes containing alkali metals and alkali earth metals such as lithium, cesium, magnesium and calcium, and quinolinol complexes thereof; and oxides and fluorides thereof such as lithium fluoride and cesium oxide. The electron transporting material or donor material is one of materials which are likely to undergo a change in performances due to a combination with the respective RGB emitting layers, and is exemplified as another preferred example to which the patterning method of the present invention is applied.

In order to extract emission from the emitting layer, at least one of the first electrode and the second electrode is preferably transparent. In case of the bottom emission in which light is extracted from the first electrode, the first electrode is transparent, while in case of the top emission in which light is extracted from the second electrode, the second electrode is transparent. In case of forming a transferring material layer for electrode on a donor substrate, the transferring material layer can be formed by various techniques similar to the emitting layer. Upon transfer, reactive transfer can be carried out, for example, a transfer material is reacted with oxygen. As the materials of the transparent electrode and the other electrode, known materials described in Japanese Unexamined Patent Publication (Kokai) No. 11-214154 can be used.

It is possible to use, as the organic light emitting device, active-matrix type device in which the second electrode is generally formed as a common electrode, a simple matrix type device which has a stripe electrode wherein the first electrode and the second electrode are crossed with each other, or a segment type device in which the display portion is patterned such that predetermined information is displayed. Examples of uses thereof include televisions, personal computers, monitors, watches, thermometers, audio instruments, display panels for automobiles and the like.

The patterning method of the present invention can be applied to not only an organic light emitting device, but also devices such as organic TFTs, photoelectric transducers and various sensors. For example, Japanese Unexamined Patent Publication (Kokai) No. 2003-304014, Japanese Unexamined Patent Publication (Kokai) No. 2005-232136, and Japanese Unexamined Patent Publication (Kokai) No. 2004-266157, shown as the prior art of the organic TFT, disclose techniques in which a semiconductor layer is formed by directly applying a precursor material of a semiconductor on a device substrate, followed by conversion. It is possible to obtain the same effect as in an organic light emitting device by forming this semiconductor layer using the patterning method of the present invention.

### Examples

The present invention will be described below by way of Examples, but the present invention is not limited to these Examples.

### Example 1

A donor substrate was prepared as follows. An alkali-free glass substrate was used as a support. After cleaning and a UV-ozone treatment of the substrate, a tantalum film having a thickness of 0.4 µm was formed on the whole surface as a light-to-heat conversion layer by the sputtering method on the whole surface. Subsequently, the light-to-heat conversion layer was subjected to a UV-ozone treatment. On this layer, a positive-type polyimide photosensitive coating agent (DL-1000, manufactured by TORAY INDUSTRIES, INC.) was spin-coated. The obtained coating film was subjected to prebaking and exposure by UV light so as to obtain a pattern of the objective transfer prevention layer, and then the exposed portion was dissolved and removed by a developing solution (ELM-D, manufactured by TORAY INDUSTRIES, INC.). The thus patterned polyimide precursor film was baked by a hot plate at 320°C for 10 minutes to form a transfer prevention layer of polyimide. The thickness of the transfer prevention layer was 7 µm and its cross section had a forward tapered shape, and the width was 20 µm. Between transfer prevention layers, apertural areas each having a width of 80 µm and a length of 280 µm for exposure of the light-to-heat conversion layer were arranged at pitches of 100 µm in a width direction and 300 µm in a length direction. A transferring material layer having a thickness of 40 nm was formed on almost the whole surface of the substrate by codeposition of a pyrene-based red host material RH-1 and a pyrromethene-based red dopant material RD-1 (0.5% by weight based on the host material).

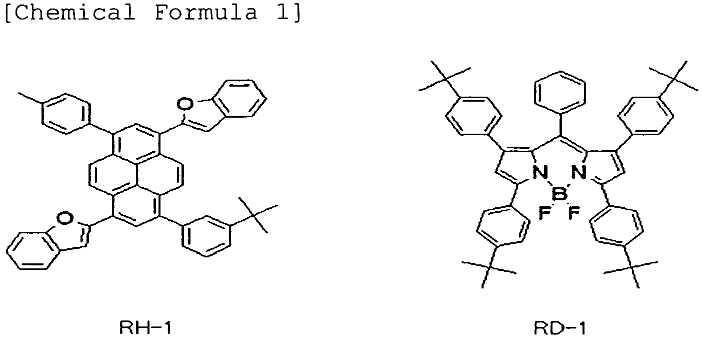

A device substrate was prepared as follows. An alkali-free glass substrate on which ITO transparent conductive coating having a thickness of 165 nm was accumulated (manufactured by Geomatec Co., Ltd., sputter-deposited product) was cut into a piece having a size of 38 x 46 mm, and the ITO was etched into a desired shape by a photolithography method. Then, a polyimide precursor film patterned in the same manner as in case of the donor substrate was baked at 300°C for 10 minutes to form a polyimide insulating layer. The height of the insulating layer was 7 µm and its cross section had a forward tapered shape, and the width was 30 µm. Between the pattern of the insulating layer, apertural areas each having a width of 70 µm and a length of 250 µm for exposure of the ITO were arranged at pitches of 100 µm in a width direction and 300 µm in a length direction. The substrate was subjected to an UV-ozone treatment and placed in a vacuum deposition apparatus, and then the air was evacuated until the vacuum degree in the apparatus became 3 × 10⁻⁴ Pa or less. By a resistance heating method, an amine-based compound N,N'-((1,1'-biphenyl)-4,4'-diyl)bis(N,N,N-triphenylbenzene-1,4-diamine) was deposited as a hole injection layer in a thickness of 50 nm and NPD was deposited as a hole transporting layer in a thickness of 10 nm, on the whole emitting region of this substrate.

Then, the position of the transfer prevention layer of the donor substrate and the position of the insulating layer of the device substrate were aligned and made to face each other, and the substrates were maintained in vacuum of 3 × 10⁻⁴ Pa or less and then removed into air after sealing the outer peripheral portion. The transfer space partitioned by the insulating layer and the transfer prevention layer was maintained in vacuum. For the transfer step, light having a center wavelength of 940 nm whose irradiation shape was formed into a rectangle of 340 µm × 50 µm (light source: semiconductor laser diode) was used. The light was irradiated from the glass substrate side of the donor substrate such that the longitudinal direction of the transfer prevention layer and the insulating layer agree with the longitudinal direction of the light, and scanning was performed in the longitudinal direction such that the transfer region and the antitransfer region were heated at the same time, thereby transferring only a transfer region (region where a transferring material layer is in contact with a light-to-heat conversion layer) of the co-deposited film as the transfer material layer onto the hole transporting layer, which is the under layer of the device substrate. The light intensity was adjusted within a range from 144 to 180 W/mm², and the scanning speed was 0.6 m/s. The scan was repeatedly carried out so as to be transferred to the whole emitting region of the device substrate while allowing light to overlap in the transverse direction at a pitch of about 300 µm.

The device substrate after the transfer was placed in the vacuum deposition apparatus again, and then the air was evacuated until the vacuum degree in the apparatus became 3 × 10⁻⁴ Pa or less. By resistance heating, the compound E-1 shown below as an electron transporting layer was vapor-deposited on the whole emitting region in a thickness of 30 nm. Subsequently, lithium fluoride as a donor material (electron injection layer) was deposited in a thickness of 0.5 nm and aluminum as a second electrode was deposited in a thickness of 100 nm to produce an organic light emitting device having an emitting region measuring 5 mm x 5 mm.

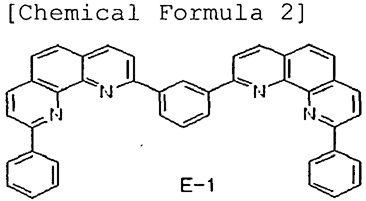

In the above transfer step, a test was carried out by changing the light intensity and the number of transfer times as shown in Table 1. Herein, "number of transfer times is 1" means that the whole film thickness of a transferring material layer having a thickness of 40 nm is just transferred by single light irradiation, and "number of transfer times is 24" means that the whole film thickness of a transferring material layer having a thickness of 40 nm is just transferred by light irradiation 24 times (average film thickness transferred by single light irradiation is about 1.7 nm). The measured values of emission efficiency in the organic light emitting device obtained under the conditions are shown in Table 1. Clear red light emission could be confirmed from any device, and it was confirmed that the transferred emitting layer sufficiently covers apertural areas of the insulating layer of the device substrate.

**Table 1**

| Light intensity | Number of transfer times | Emission efficiency |
|---|---|---|
| (W/mm²) | | (cd/A) |
| 180 | 1 | 0.2 |
| 154 | 12 | 2.6 |
| 149 | 24 | 5.1 |
| 144 | 36 | 5.0 |

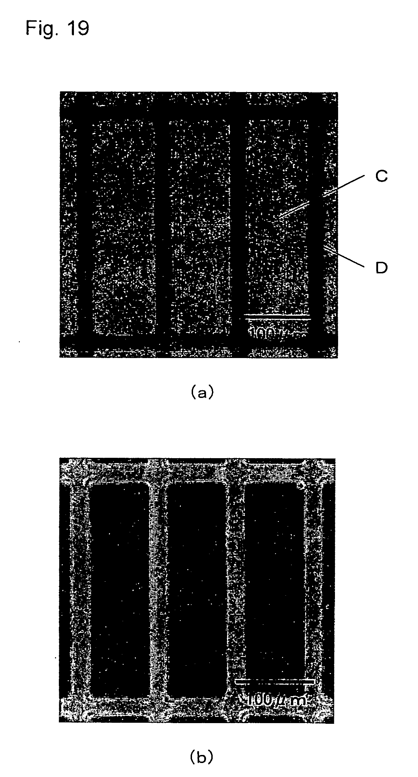

Plane fluorescence micrographs of a donor substrate before and after transfer in the present Example are shown in Fig. 19. In Fig. 19(a), fluorescence from the transfer material is detected in both the transfer region (on light-to-heat conversion layer) and the antitransfer region (on transfer prevention layer) before the transfer (fluorescence in the antitransfer region appears relatively dark due to a difference in reflectance of the under layer). In Fig. 19(b), fluorescence from the transfer material in the transfer region is not detected after the transfer and thus this reveals that the transfer material in the transfer region was transferred to the device substrate. On the other hand, fluorescence from the transfer material in the antitransfer region is detected and also adhesion of the transfer material to the device substrate corresponding to the present region was not recognized, and thus it was recognized that the transfer material in the antitransfer region is not transferred.

### Example 2

In the same manner as in Example 1, except that a 0.2 µm thick tantalum film was formed on the whole surface as the first light-to-heat conversion layer in the production of the donor substrate, an operation was carried out up to patterning of the transfer prevention layer. Then, a 0.2 µm thick tantalum film was formed on the whole surface as a second light-to-heat conversion layer. Namely, the donor substrate of the present Example has a structure that a 0.4 µm thick tantalum film is formed in a transfer region, and a polyimide-based'transfer prevention layer is sandwiched between two tantalum films in an antitransfer region. In the same manner as in Example 1, a 40 nm thick transferring material layer was formed on almost the whole surface of the substrate.

In the same manner as in Example 1, except for others, an organic light emitting device was produced. As a result, almost the same emission efficiency as that in Example 1 was obtained. Furthermore, in the donor substrate of the present Example, a transferring material layer is also in contact with a stable metal (tantalum) layer in the antitransfer region. Therefore, there was recognized an advantage that mixing of impurities can be suppressed in case of recovering a transfer material, which remains adhered in the antitransfer region after the transfer, using a solvent or the like. Furthermore, since an outermost surface of the donor substrate is covered with stable metal (tantalum), repeating durability in case of recycling by cleaning was remarkably improved.

When utilizing the above-mentioned principle, it is possible to easily achieve pattern transfer of the respective RGB transferring material layers with high accuracy, as described with reference to Fig. 2 and Fig. 3.

### Industrial Applicability

The present invention is directed to patterning technology of thin films which constitute devices such as organic TFTs, photoelectric transducers and various sensors, including organic light emitting devices, and can be used to the production of display panels, touch panels, image pickup devices and the like which are used in cellular phones, personal computers, televisions, image scanners and the like.

### [Description of Symbols]

- 10:: Organic light emitting device (Device substrate)
- 11:: Support
- 12:: TFT (including extraction electrode)
- 13:: Planarizing layer
- 14:: Insulating layer
- 15:: First electrode
- 16:: Hole transporting layer
- 17:: Emitting layer
- 18:: Electron transporting layer
- 19:: Second electrode
- 20:: Device substrate
- 21:: Support
- 27:: Transfer film
- 30:: Donor substrate
- 31:: Support
- 33:: Light-to-heat conversion layer
- 34:: Transfer prevention layer
- 37:: Transferring material layer
- 38:: Screen
- 39:: Transfer aid layer
- 41:: Optical mask
- 42:: Lens
- 43:: Mirror
- 44:: Light source
- 45:: Virtual focal plane
- A:: Irradiation light
- B:: Scan direction
- C:: Transfer region
- D:: Antitransfer region
- E:: Overlap

## Claims

1. A donor substrate comprising a support; a light-to-heat conversion layer and a transfer prevention layer formed on the support; and a transferring material layer formed on a top surface of the light-to-heat conversion layer and the transfer prevention layer; wherein a transfer region and an antitransfer region are formed by combinations of the light-to-heat conversion layer and the transfer prevention layer, and the transferring material layer is formed on the whole surface of the transfer region and at least one part of the antitransfer region.

2. The donor substrate according to claim 1, wherein the transferring material layer is formed on almost the whole top surface of the light-to-heat conversion layer and the transfer prevention layer.

3. The donor substrate according to claim 1 or 2, wherein the thickness of the antitransfer region is five or more times the thickness of the transfer region.

4. The donor substrate according to any one of claims 1 to 3, wherein the light-to-heat conversion layer is formed on almost the whole surface of the support; the transfer prevention layer is pattern-formed on the light-to-heat conversion layer; a formation portion of the transfer prevention layer functions as an antitransfer region; and a non-formation portion of the transfer prevention layer functions as a transfer region.

5. The donor substrate according to any one of claims 1 to 3, wherein the transfer prevention layer is pattern-formed on the support; a light-to-heat conversion layer is formed on almost the whole surface including the surface of the transfer prevention layer; the portion where the transfer prevention layer is formed is an antitransfer region; and the portion where the transfer prevention layer is not formed is a transfer region.

6. The donor substrate according to any one of claims 1 to 5, wherein the portion in contact with the transferring material layer is made of an inorganic substance.

7. The donor substrate according to any one of claims 1 to 6, wherein the transferring material layer is formed by a dry process.

8. A patterning method, which comprises arranging the donor substrate according to any one of claims 1 to 7 and a device substrate oppositely to each other; and irradiating light from the support side of the donor substrate so that at least one part of a transfer region and at least one part of an antitransfer region are simultaneously heated, thereby transferring only a transfer region portion of a transferring material layer to the device substrate.

9. The patterning method according to claim 8, wherein light having a width larger than that of the transfer region is irradiated with the light-to-heat conversion layer.

10. The patterning method according to claim 8 or 9, wherein the transferring material layer is dividedly transferred in plural times in a film thickness direction by dividedly irradiating light in plural times.

11. A method for producing a device, which comprises patterning at least one layer of layers constituting a device by the method according to any one of claims 8 to 10.

12. The method for producing a device according to claim 11, wherein the device is an organic light emitting device, and the layer to be patterned is an emitting layer.
